(19) Europäisches Patentamt / European Patent Office / Office européen des brevets

(11) **EP 3 457 151 B1**

(12) **EUROPEAN PATENT SPECIFICATION**

(45) Date of publication and mention of the grant of the patent:
**13.05.2020  Bulletin 2020/20**

(51) Int Cl.:
**G01R 31/36** *(2020.01)*     **G01R 31/389** *(2019.01)*

(21) Application number: **18183684.2**

(22) Date of filing: **16.07.2018**

(54) **IMPEDANCE ESTIMATING APPARATUS**

IMPEDANZSCHÄTZUNGSVORRICHTUNG

APPAREIL D'ESTIMATION DE L'IMPÉDANCE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.08.2017   JP 2017161206**

(43) Date of publication of application:
**20.03.2019   Bulletin 2019/12**

(73) Proprietor: **TOYOTA JIDOSHA KABUSHIKI KAISHA**
**Toyota-shi, Aichi 471 8571 (JP)**

(72) Inventors:
• **OGUMA, Yasumasa**
  **Toyota-shi, Aichi 471-8571 (JP)**
• **OSAKA, Tetsuya**
  **Shinjuku-ku, Tokyo 169-8050 (JP)**
• **TSUDA, Shingo**
  **Shinjuku-ku, Tokyo 169-8050 (JP)**
• **UTSUMI, Kazuaki**
  **Shinjuku-ku, Tokyo 169-8050 (JP)**
• **YOKOSHIMA, Tokihiko**
  **Shinjuku-ku, Tokyo 169-8050 (JP)**
• **MUKOYAMA, Daikichi**
  **Shinjuku-ku, Tokyo 169-8050 (JP)**

(74) Representative: **TBK**
**Bavariaring 4-6**
**80336 München (DE)**

(56) References cited:
**JP-B2- 3 642 092        US-A1- 2016 103 184**
**US-A1- 2016 187 429**

• **JIANG JIUCHUN ET AL: "A reduced low-temperature electro-thermal coupled model for lithium-ion batteries", APPLIED ENERGY, ELSEVIER SCIENCE PUBLISHERS, GB, vol. 177, 13 June 2016 (2016-06-13), pages 804-816, XP029629023, ISSN: 0306-2619, DOI: 10.1016/J.APENERGY.2016.05.153**

## Description

BACKGROUND

1. Technical Field

Embodiments of the present disclosure relate to an impedance estimating apparatus configured to estimate an impedance of a battery mounted on a vehicle or the like.

2. Description of the Related Art

On this of apparatus, an impedance is estimated to know, for example, a charge amount of a battery. For example, International Publication No. WO2013/114669 (Patent Literature 1) discloses a proposed technique/technology in which the charge amount of the battery is detected from a slope angle of a straight line connecting two or more complex impedances with different frequencies.

Moreover, Japanese Patent Application Laid Open No. 2014-126532 (Patent Literature 2) discloses a technique/technology in which a response signal to an inputted rectangular wave signal is Fourier-transformed and in which an impedance characteristic of an electrochemical cell is calculated on the basis of a calculated frequency characteristic. International Publication No. WO2013/018641 (Patent Literature 3) discloses a technique/technology in which an internal impedance is measured by using a signal with a frequency that is hardly followed by ions in a power storage apparatus and in which an internal temperature of the power storage apparatus is calculated from a measured value. Japanese Patent Application Laid Open No. 2008-157757 (Patent Literature 4) discloses a technique/technology in which an influence on the internal impedance caused by a change in a charging rate and temperature of the battery is corrected to estimate the internal impedance at a predetermined temperature and a predetermined charging rate.

The impedance of the battery is caused by charge transfer or the like, and thus has a significant temperature dependence. Therefore, in order to accurately estimate the impedance of the battery by using the techniques/technologies described in the above Patent Literatures, it is desirable to perform an estimation process after setting the temperature of the battery at a reference temperature, i.e., under a predetermined temperature condition.

The temperature of the battery, however, varies depending on a use state of the battery. Thus, for example, if the impedance of the battery mounted on the vehicle is to be estimated during running of the vehicle, it is hard to perform the estimation process after setting the temperature of the battery at the reference temperature. Therefore, when the techniques/technologies described in the above Patent Literatures are used, the impedance of the battery may not be accurately detected due to the variation in temperature of the battery, which is technically problematic. Prior art is disclosed in document JP 3 642092 B2 describing a method for detecting internal resistance of a secondary battery for an electric automobile and an output meter of electric automobile employing IT, as well as in document US 2016/103184 A1 describing a battery state estimation apparatus as well as in document US 2016/187429 A1 describing an apparatus for predicting power parameter of a secondary battery as well as in document Jiang Jiuchun et al., in Applied Energy, Elsevier Science Publishers, GB, DOI: 10.1016/J.APENERGY.2016.05.153 describing a reduced low-temperature electro-thermal coupled model for lithium-ion batteries.

SUMMARY

In view of the aforementioned problems, it is therefore an object of embodiments of the present disclosure to provide an impedance estimating apparatus configured to accurately estimate the impedance of the battery.

The above object of embodiments of the present disclosure is achieved by an impedance estimating apparatus provided with: a deriving device configured to derive a plurality of slope functions, on the basis of values of complex impedances of a battery at a plurality of frequencies out of values obtained at a plurality of different temperatures and on the basis of temperatures of the battery when the complex impedances are obtained, in a frequency area higher than an area of Cole-Cole plotted complex impedances that belongs to ion diffusion, wherein each of the plurality of slope functions indicates a relation between the values of the complex impedances at the plurality of frequencies and inverses of the temperatures of the battery; and an estimator configured (i) to estimate, at a first temperature, real components at the plurality of frequencies that form a first arc component of the complex impedances by using the plurality of slope functions and to estimate an imaginary component at a peak frequency of the first arc component of the complex impedances by using a slope function corresponding to the peak frequency from among the plurality of slope functions, (ii) to estimate a second arc component of the complex impedances from the estimated real components and the estimated imaginary component, and (iii) to estimate a value of the complex impedance corresponding to a second temperature of the battery from the second arc component.

BRIEF DESCRIPTION OF THE DRAWINGS

FIG. 1 is a block diagram illustrating a configuration of an impedance estimating apparatus according to an example helpful for understanding the present invention;

FIG. 2 is a graph illustrating waveforms of complex impedances measured at 20 degrees C, 25 degrees C, and 30 degrees C;

FIG. 3 is a graph illustrating waveforms of the complex impedances measured at 40 degrees C, 45 degrees C, and 50 degrees C;

FIG. 4 is a flowchart illustrating a flow of operations of the impedance estimating apparatus according to the example helpful for understanding the present invention;

FIG. 5 is a graph illustrating a relation between an absolute value of the complex impedance and an inverse of temperature;

FIG. 6 is a graph illustrating a relation between a real component of the complex impedance and the inverse of the temperature;

FIG. 7 is a graph illustrating a relation between an imaginary component of the complex impedance and the inverse of the temperature;

FIG. 8 is graphs respectively illustrating relations between values of the complex impedances measured in different SOCs and the inverses of the temperatures;

FIG. 9 is a graph illustrating a partially enlarged arc component of a Cole-Cole plot;

FIG. 10 is a flowchart illustrating a flow of operations of an impedance estimating apparatus according to a second embodiment;

FIG. 11 is a graph illustrating a relation between the real component of the complex impedance and the inverse of the temperature in a frequency band corresponding to the arc component; and

FIG. 12 is a graph illustrating a relation between the imaginary component of the complex impedance and the inverse of the temperature in the frequency band corresponding to the arc component.

DETAILED DESCRIPTION OF THE EMBODIMENTS

An impedance estimating apparatus according to embodiments of the present disclosure will be explained with reference to the drawings.

<Example helpful for understanding the present invention>

An impedance estimating apparatus 100 according to an example helpful for understanding the present invention will be explained. The following is an example in which the impedance estimating apparatus 100 is configured to estimate an impedance of a battery 10 of a vehicle.

(1) Configuration of Apparatus

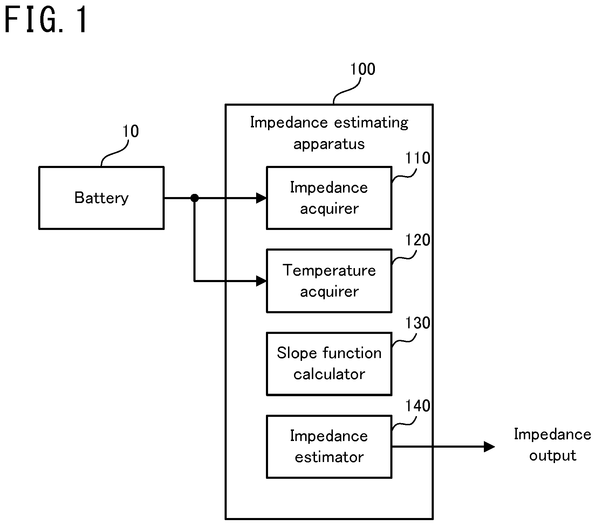

Firstly, a configuration of the impedance estimating apparatus 100 according to the example helpful for understanding the present invention will be explained with reference to FIG. 1. FIG. 1 is a block diagram illustrating the configuration of the impedance estimating apparatus 100 according to the example helpful for understanding the present invention.

As illustrated in FIG. 1, the impedance estimating apparatus 100 according to the example helpful for understanding the present invention is an electronic unit electrically connected to the battery 10 of the vehicle, and is configured to estimate the impedance, i.e., a complex impedance, of the battery 10. The battery 10 is a specific example of the "battery" in Supplementary Note described later, and is configured as a chargeable aqueous secondary battery, such as, for example, a lithium ion battery.

The impedance estimating apparatus 100 is provided with an impedance acquirer 110, a temperature acquirer 120, a slope function calculator 130, and an impedance estimator 140, as logical or physical processing blocks realized therein.

The impedance acquirer 110 is configured to obtain the complex impedance of the battery 10. The impedance acquirer 110 is configured to obtain the complex impedance, for example, by applying an alternating current (AC) voltage to the battery 10 while changing a frequency. A method of obtaining the complex impedance can use the exiting technique/technology, as occasion demands, and a detailed explanation herein will be thus omitted. The complex impedance of the battery 10 obtained by the impedance acquirer 110 may be outputted to the slope function calculator 130.

The temperature acquirer 120 is configured to obtain a temperature of the battery 10, or preferably, a temperature of an electrode. The temperature acquirer 120 is particularly configured to obtain the temperature when the impedance acquirer 110 obtains the complex impedance of the battery 10. A method of obtaining the temperature can use the exiting technique/technology, as occasion demands, and a detailed explanation herein will be thus omitted. The temperature of the battery 10 obtained by the temperature acquirer 120 may be outputted to the slope function calculator 130.

The slope function calculator 130 is a specific example of the "deriving device" in Supplementary Notes described later, and is configured to derive a slope function indicating a relation between the complex impedance of the battery 10 obtained by the impedance acquirer 110 and the temperature of the battery 10 obtained by the temperature acquirer 120. The slope function, which will be detailed later, is a function indicating that the complex impedance of the battery 10 and an inverse of the temperature of the battery 10 are in a linear relation. The slope function calculated by the slope function calculator 130 may be outputted to the impedance estimator 140.

The impedance estimator 140 is a specific example of the "estimator" in Supplementary Notes described later, and is configured to estimate the complex impedance of the battery 10 at a predetermined reference temperature by using the slope function calculated by the slope function calculator 130. More specifically, the impedance estimator 140 is configured to estimate a value that is to be obtained if the battery 10 is at the predetermined reference temperature, from the complex impedance of the battery 10 obtained by the impedance acquirer 110. The value of the complex impedance estimated by the impedance estimator 140 may be outputted to the outside of the apparatus, and may be used as a parameter for estimating a current state of the battery 10, such as, for example, a state of charge (SOC) and a state of health (SOH).

(2) Temperature Dependence of Complex Impedance and Problems

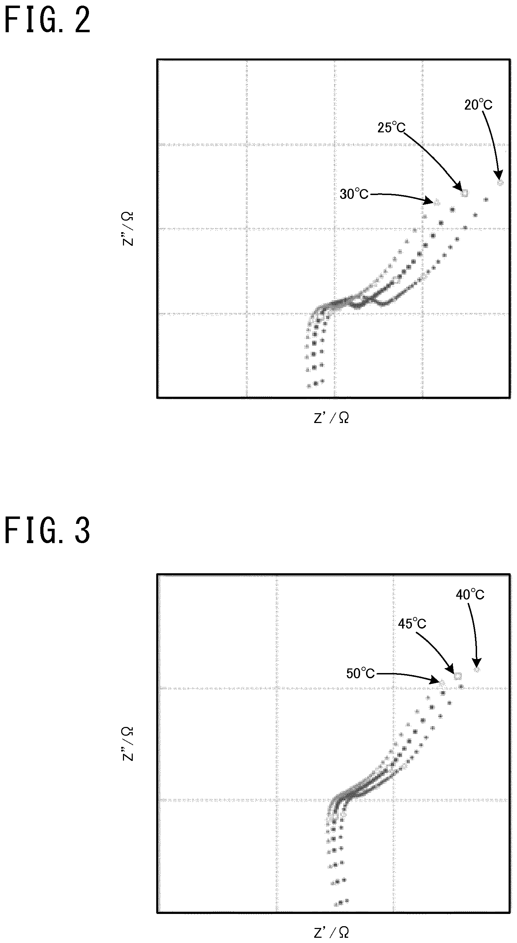

Next, a temperature dependence of the complex impedance of the battery 10 will be explained with reference to FIG. 2 and FIG. 3. FIG. 2 is a graph illustrating waveforms of complex impedances measured at 20 degrees C, 25 degrees C, and 30 degrees C. FIG. 3 is a graph illustrating waveforms of the complex impedances measured at 40 degrees C, 45 degrees C, and 50 degrees C. Data illustrated in FIG. 2 and FIG. 3 is measured when the battery 10 has a SOC of 95%.

As illustrated in FIG. 2 and FIG. 3, when complex impedances obtained at temperatures of the battery 10 of 20 degrees C, 25 degrees C, and 30 degrees C and 40 degrees C, 45 degrees C, and 50 degrees C are plotted on a complex plane, the complex impedances are drawn as different curves that are shifted to the right side with decreasing temperature. This indicates that the complex impedance of the battery 10 has a significant temperature dependence. The temperature dependence of the complex impedance is caused by diffusion of lithium ions and charge transfer inside the battery 10

As described above, the complex impedance of the battery 10 significantly varies depending on the temperature of the battery 10 when measured. Thus, if the state of the battery 10 is estimated by using the complex impedance, it is preferable to use the complex impedance measured at the predetermined reference temperature. In other words, it is preferable to use the complex impedance measured under a predetermined temperature condition. It is, however, not easy to set the temperature of the battery 10 at the predetermined reference temperature before the measurement. In particular, during the running of the vehicle equipped with the battery 10, the temperature of the battery 10 rises or falls due to a charging/ discharging operation. It is thus hard to maintain the battery 10 at the reference temperature.

To solve the aforementioned problems, a possible method is to convert or correct the complex impedance obtained at any temperature to the complex impedance obtained at the reference temperature. However, if the existing technique/technology is used to convert the complex impedance, a relatively advanced and complicated process, such as Fitting analysis, is required. Thus, for example, if the complex impedance is measured in real time on a running vehicle or the like, it is not easy to convert at each time the complex impedance to a value corresponding to the reference temperature.

The impedance estimating apparatus 100 according to the example helpful for understanding the present invention is configured to perform operations detailed below, to solve the aforementioned problems.

(3) Explanation of Operation

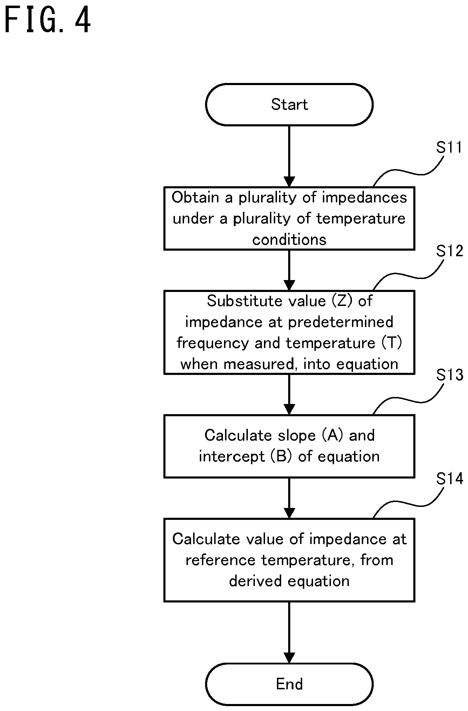

The operations performed by the impedance estimating apparatus 100 according to the example helpful for understanding the present invention will be explained with reference to FIG. 4. FIG. 4 is a flowchart illustrating a flow of the operations of the impedance estimating apparatus according to the example helpful for understanding the present invention.

In FIG. 4, in operation of the impedance estimating apparatus 100 according to the example helpful for understanding the present invention, a plurality of complex impedances are firstly obtained under a plurality of temperature conditions (step S11). More specifically, a complex impedance of the battery 10 is obtained by the impedance acquirer 110, and a temperature of the battery 10 at that time may be obtained by the temperature acquirer 120.

The obtained complex impedances of the battery 10 can be divided by each frequency. In the following process, complex impedances at a predetermined frequency may be obtained under the plurality of temperature conditions. In this case, an absolute value, a real component (i.e., a real part), and an imaginary component (i.e., an imaginary part) are obtained for the complex impedances at the predetermined frequency. The "predetermined frequency" here is a frequency corresponding to a slope component of Cole-Cole plotted complex impedances (i.e., a straight line part in FIG. 2 and FIG. 3).

The obtained complex impedances of the battery 10 (whose values will be hereinafter expressed as Z0) and the temperatures of the battery 10 (whose values will be hereinafter expressed as T0) when the corresponding complex impedances are obtained may be inputted to the slope function calculator 130, so that a slope function for estimating the complex impedance may be derived. The slope function calculator 130 substitutes the values Z0 of the complex impedances at the predetermined frequency of the battery 10 and the temperatures T0 of the battery 10 when the corresponding complex impedances are obtained, into a numerical expression stored in advance (i.e., a numerical expression (1) described below) (step S12).

According to studies by the present inventors, it has been found that a relation of the following equation (1) is established between a value Z of the complex impedance at the predetermined frequency and a temperature T of the battery 10.

$$logZ=A\times(1/T)+B \quad \cdots (1)$$

Thus, if a slope A and an intercept B are obtained after the temperatures T0 and the values Z0 of the complex impedance of the battery actually obtained are substituted into the equation (1) (step S13), it is possible to derive a slope function indicating the relation between the temperature T and the value Z of the complex impedance of the battery 10.

The slope function derived in this manner may be outputted to the impedance estimator 140 and may be used to estimate the value Z of the complex impedance corresponding to a predetermined temperature. Specifically, the impedance estimator 140 substitutes the predetermined reference temperature into T in the slope function, thereby calculating the value Z of the complex impedance corresponding to the predetermined reference temperature (step S14).

(4) Method of Deriving Slope Function

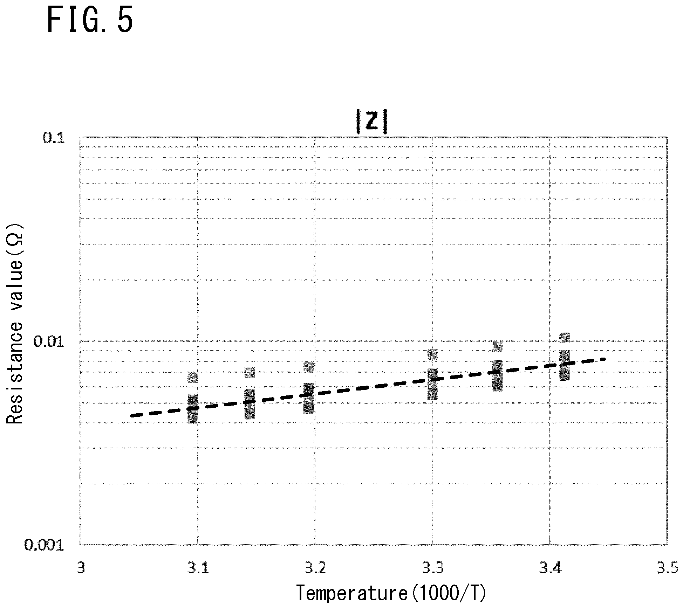

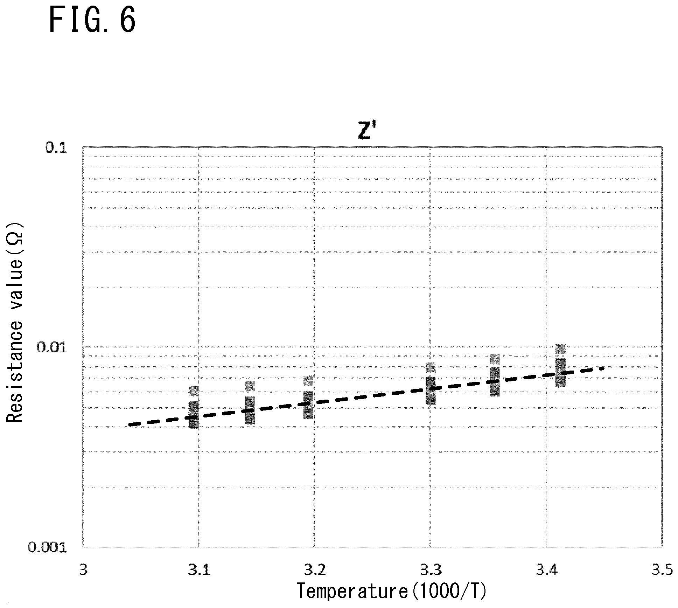

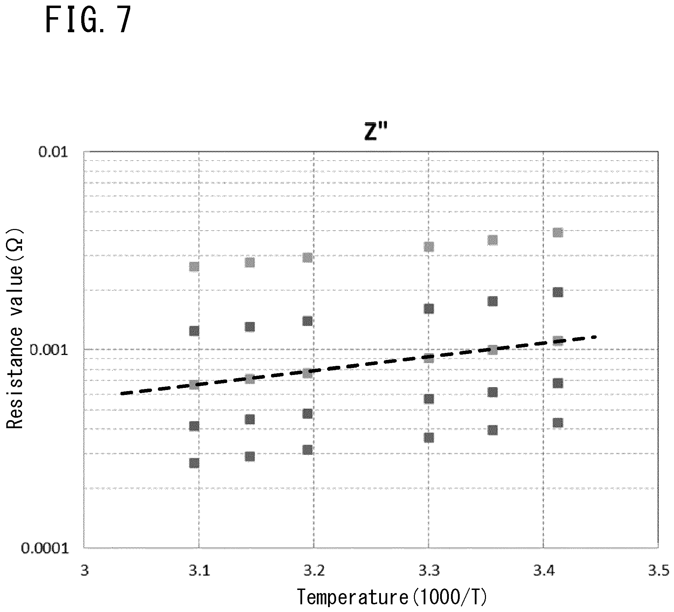

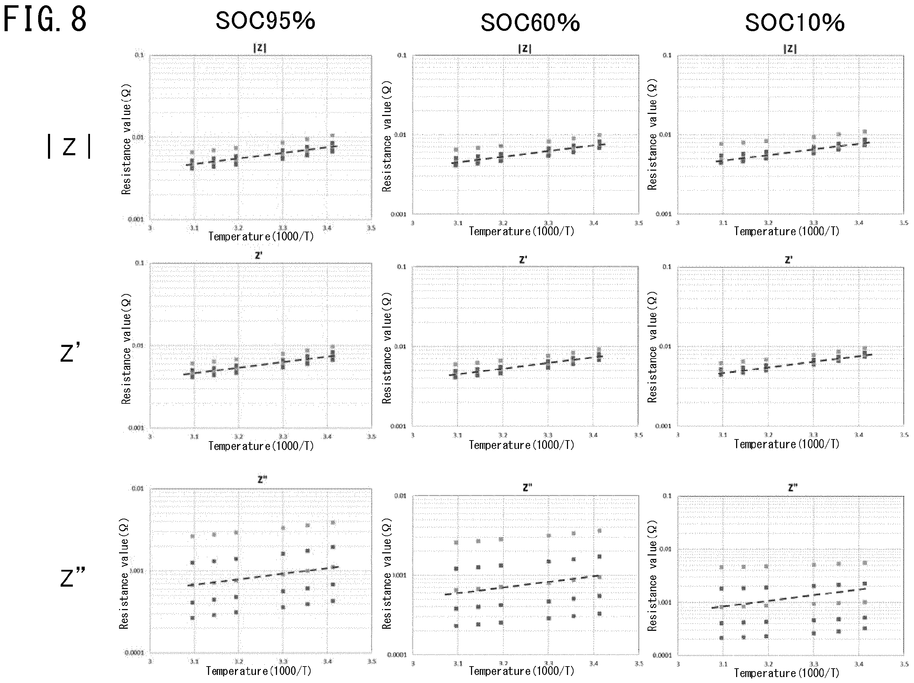

Next, a specific method of deriving the slope function described above will be explained with reference to FIG. 5 to FIG. 8. FIG. 5 is a graph illustrating a relation between an absolute value of the complex impedance and an inverse of the temperature. FIG. 6 is a graph illustrating a relation between a real component of the complex impedance and the inverse of the temperature. FIG. 7 is a graph illustrating a relation between an imaginary component of the complex impedance and the inverse of the temperature. FIG. 8 is graphs respectively illustrating relations between values of the complex impedances measured in different SOCs and the inverses of the temperatures. A numerical value on a horizontal axis in each of FIG. 5 to FIG. 8 is a numerical value when the temperature T is measured by the absolute temperature.

As illustrated in FIG. 5 to FIG. 7, a plurality of types of slope functions are derived by using an absolute value |Z|, a real component Z', and an imaginary component Z" for the complex impedances. In other words, a slope function for the absolute value |Z|, a slope function for the real component Z', and a slope function for the imaginary component Z" are separately derived. The slope function may be not always derived for all the absolute value |Z|, the real component Z', and the imaginary component Z", and the slope function may be derived for at least one of the absolute value |Z|, the real component Z', and the imaginary component Z".

In FIG. 5, the absolute value |Z| for the complex impedances measured in a range in which the temperature T of the battery is 20 to 50 degrees C changes linearly with respect to a variation in the temperature T. Specifically, connecting points corresponding to the same frequency provides a straight line (refer to a dashed line in FIG. 5). As described above, if the absolute value |Z| of the complex impedance and the temperature T when the value is obtained are used and plotted to obtain an approximate straight line, which connects plotted points, the slope function can be derived for the absolute value |Z| of the complex impedance.

In FIG. 6, the real component Z' for the complex impedances measured in the range in which the temperature T of the battery is 20 to 50 degrees C also changes linearly with respect to the variation in the temperature T, as in the absolute value |Z| illustrated in FIG. 5. Thus, if the real component Z' of the complex impedance and the temperature T when a value of the real component Z' is obtained are used and plotted to obtain an approximate straight line, which connects plotted points, the slope function can be derived for the real component Z' of the complex impedance.

In FIG. 7, the imaginary component Z" for the complex impedances measured in the range in which the temperature T of the battery is 20 to 50 degrees C also changes linearly with respect to the variation in the temperature T, as in the absolute value |Z| illustrated in FIG. 5 and the real component Z' illustrated in FIG. 6. Thus, if the imaginary component Z" of the complex impedance and the temperature T when a value of the imaginary component Z" is obtained are used and plotted to obtain an approximate straight line, which connects plotted points, the slope function can be derived for the imaginary component Z" of the complex impedance.

In FIG. 8, straight lines corresponding to the same slope function are overlapped on graphs obtained when the temperatures T0 and the values Z0 of the complex impedances of the battery 10 are obtained in different SOCs (i.e., 95%, 60%, 10%). As can be seen, a plurality of points corresponding to the same frequency are connected by a straight line on each of the graphs of the absolute value |Z|, the real component Z', and the imaginary component Z". This indicates that the same slope function is derived in each of the absolute value |Z|, the real component Z', and the imaginary component Z', even in different SOCs.

In the imaginary component Z", however, data for SOC 10% has a part in which the data is significantly shifted from the straight line. In other words, in the imaginary component Z", an error that cannot be ignored possibly occurs according to measurement circumstances. Thus, in a situation in which only the absolute value |Z| and the real component Z' are sufficient for the value Z of the impedance to be calculated, the slope function may be derived only for at least one of the absolute value |Z| and the real component Z'; namely, the slope function may not be derived for the imaginary component Z".

In the examples illustrated in FIG. 5 to FIG. 7, the slope function is derived as the approximate straight line, which connects a plurality of points; however, the approximate straight line, i.e., the slope function, can be derived from a point if any of the slope A and the intercept B of the slope function is known. In other words, if the slope A or the intercept B of the slope function is known, it is not necessary to obtain the plurality of temperatures T0 and the plurality of values Z0 of the complex impedance. It is possible to derive the slope function only from a pair of the temperature T0 and the value Z0 of the complex impedance.

If the plurality of points are not used, it is considered that an influence of measurement errors may be increased in the measurement of the complex impedances and the temperatures of the battery 10. Specifically, it is hardly possible to remove an influence of noise by using the plurality of points. Thus, if the slope function is derived from a point, data measured at a temperature at which measurement accuracy is ensured may be used. The "temperature at which the measurement accuracy is ensured" is a temperature of the battery 10 corresponding to a situation in which an event that causes a reduction in the measurement accuracy unlikely occurs.

For example, the battery 10 may have a variation in internal temperature due to a temperature change, and the temperature T cannot be accurately measured in some cases. Thus, if data measured in this situation is used, it is hardly possible to accurately derive the slope function. Therefore, if the slope function is derived from a point, it is preferable to use data measured in a situation in which there is no variation in internal temperature of the battery 10. An example of the situation in which there is no variation in internal temperature of the battery 10 is immediately after the start of a vehicle on which the battery 10 is mounted.

(5) Technical Effect

As explained above, according to the impedance estimating apparatus in the example helpful for understanding the present invention, it is possible to relatively easily estimate the value Z of the complex impedance corresponding to a desired temperature, by using the slope function indicating the relation between the value Z of the complex impedance and the inverse of the temperature T of the battery 10. Thus, for example, the complex impedance measured under any temperature condition can be converted to the value Z of the complex impedance corresponding to the predetermined reference temperature. In other words, without actually setting the temperature of the battery 10 at the predetermined reference temperature, it is possible to know the value Z of the complex impedance, which is to be measured when the battery 10 is at the predetermined reference temperature. As a result, the estimation of the state of the battery 10 using the value Z of the complex impedance, or similar operations, can be preferably performed.

The derived slope function does not change unless the configuration of the battery 10 changes. In other words, unless the battery 10 is replaced by a new one, the same slope function can be used to estimate the complex impedance. Thus, once the slope function is derived, it is not necessary to derive a new slope function at each time.

If a plurality of complex impedances of a plurality types of batteries 10 are estimated, a plurality of slope functions respectively corresponding to the plurality of types of batteries 10 may be used. In this case, the slope function may be newly derived in timing in which the type of the battery 10 is changed. Alternatively, the plurality of slope functions respectively corresponding to the plurality of types of batteries 10 may be derived and stored in advance, and a slope function that is to be used may be selected from them, as occasion demands.

In order to select the slope function that is to be used from the plurality of slope functions stored, the value Z of the complex impedance of the battery 10 may be measured under a temperature condition in which the measurement accuracy is ensured. The value Z of the complex impedance and the temperature T measured in this manner have high measurement accuracy and have accurate values. Thus, if a slope function that is established after the substitution of the values is found, it is possible to appropriately select the slope function to be used, i.e., the slope function corresponding to the battery 10 at that time.

<Second Embodiment>

An impedance estimating apparatus according to a second embodiment will be explained. The second embodiment is partially different from the example helpful for understanding the present invention in operation, and the other part is substantially the same. Thus, hereinafter, a different part from that of the example helpful for understanding the present invention will be explained in detail, and an explanation of the same part will be omitted.

(1) Frequency Band Corresponding to Arc Component

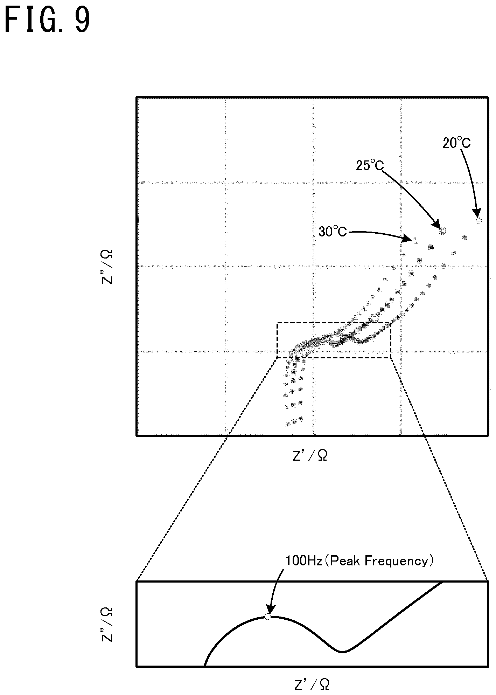

Firstly, a frequency band of the complex impedance targeted by the impedance estimating apparatus according to the second embodiment will be explained with reference to FIG. 9. FIG. 9 is a graph illustrating a partially enlarged arc component of a Cole-Cole plot.

As illustrated in FIG. 9, Cole-Cole plotted complex impedances include an arc component, i.e., a curved component with a relatively high frequency (refer to an enlarged part in FIG. 9), in addition to a slope component, which is a frequency band estimated by the impedance estimating apparatus according to the example helpful for understanding the present invention, i.e., a linear component with a relatively low frequency.

The arc component of the Cole-Cole plotted complex impedances is located in a frequency area higher than an area that belongs to ion diffusion of the battery 10. The impedance estimating apparatus according to the second embodiment is configured to estimate the complex impedances in a frequency band corresponding to the arc component. An explanation below indicates that a peak frequency of the arc component to be estimated, i.e., a frequency corresponding to a highest part of the arc component, is 100Hz.

(2) Explanation of Operation

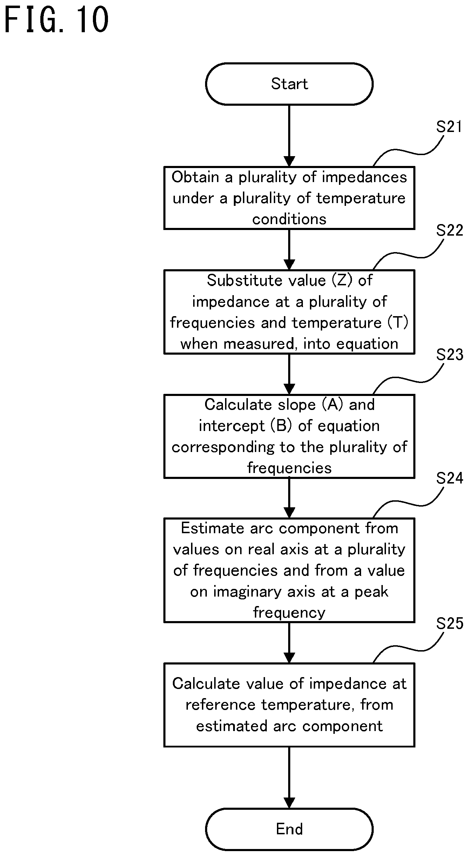

Operations performed by the impedance estimating apparatus according to the second embodiment will be explained with reference to FIG. 10. FIG. 10 is a flowchart illustrating a flow of the operations of the impedance estimating apparatus according to the second embodiment.

In FIG. 10, the impedance estimating apparatus according to the second embodiment obtains the values Z0 of the complex impedances of the battery 10 and the temperatures T0 of the battery 10 when the corresponding complex impedances are measured, under a plurality of temperature conditions (step S21).

The slope function calculator 130 then substitutes the values Z0 of the complex impedances at the predetermined frequency of the battery 10 and the temperatures T0 of the battery 10 when the corresponding complex impedances are obtained, into a numerical expression stored in advance (i.e., the numerical expression (1) described above) (step S22) and obtains the slope A and the intercept B (step S23), so that the slope function is derived.

A process performed to derive the slope function in the second embodiment is substantially the same as the process performed in the example helpful for understanding the present invention (refer to the step S11 to the step S13 in FIG. 4). In the second embodiment, however, two types of slope functions, which are for the real component Z' and the imaginary component Z" of the complex impedance, may be derived. In the example helpful for understanding the present invention, one slope function regarding the predetermined frequency may be calculated. In contrast, in the second embodiment, the slope function may be calculated for the real component Z' of the complex impedance corresponding to each of a plurality of frequencies included in the frequency band corresponding to the arc component. In other words, a plurality of slope functions are derived for the real components Z' of the complex impedances. On the other hand, one slope function for the imaginary component Z" of the complex impedance corresponding to the peak frequency of the arc component (which is 100 Hz herein) may be derived.

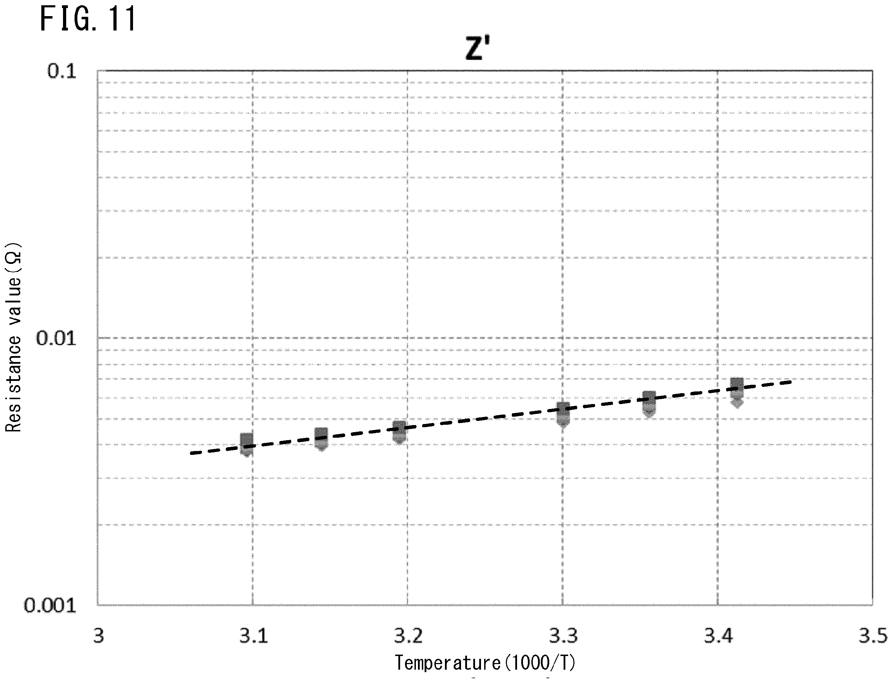

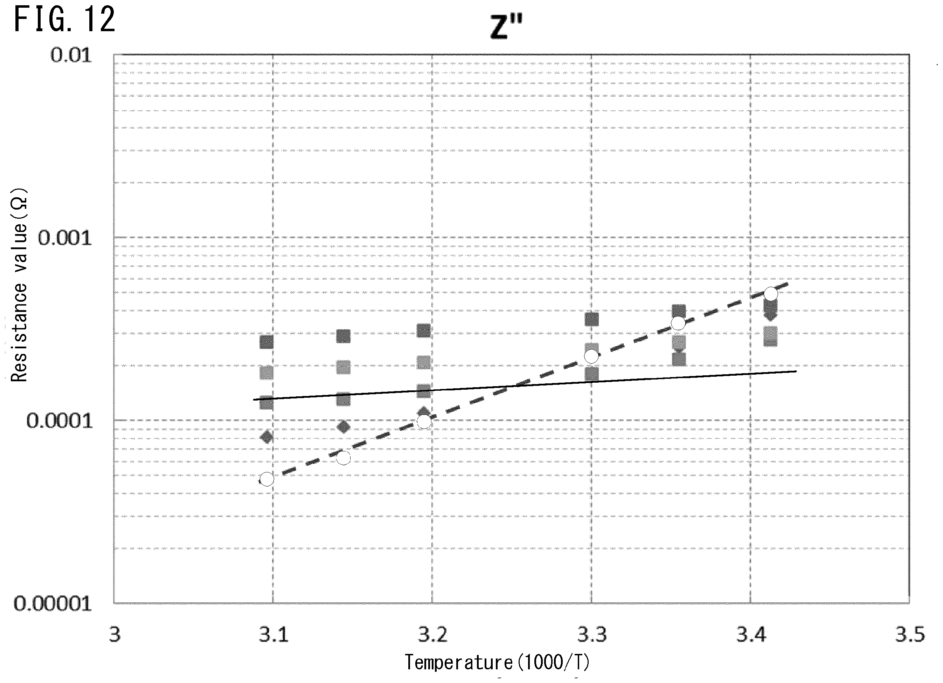

Here, with reference to FIG. 11 and FIG. 12, an explanation will be given to the reason why only the slope function for the imaginary component Z" of the complex impedance corresponding to the peak frequency is derived. FIG. 11 is a graph illustrating a relation between the real component of the complex impedance and the inverse of the temperature in the frequency band corresponding to the arc component. FIG. 12 is a graph illustrating a relation between the imaginary component of the complex impedance and the inverse of the temperature in the frequency band corresponding to the arc component.

As illustrated in FIG. 11, the real component Z' for the complex impedances of the arc component changes linearly with respect to a variation in the temperature T. In other words, it changes in the same manner as that of the real component Z' for the complex impedances of the slope component illustrated in FIG. 6. Thus, for the real component Z' of the complex impedance, it is possible to estimate an accurate value for each of the plurality of frequencies corresponding to the arc component by using the slope function as in the example helpful for understanding the present invention. Thus, regarding the slope function for the real component Z' of the complex impedance, a plurality of slope functions are derived for the plurality of frequencies corresponding to the arc component.

On the other hand, as illustrated in FIG. 12, the imaginary component Z" for the complex impedances of the arc component does not change linearly with respect to the variation in the temperature T (refer to a solid line in FIG. 12). In other words, it changes in a different manner from that of the imaginary component Z" for the complex impedances of the slope component illustrated in FIG. 7. Thus, for the imaginary component Z" of the complex impedance, it is hardly possible to estimate an accurate value for each of the plurality of frequencies corresponding to the arc component even by using the slope function as in the example helpful for understanding the present invention. However, the imaginary component Z" of the complex impedance corresponding to the peak frequency of the arc component changes linearly with respect to the variation in the temperature T (refer to a dashed line in FIG. 12). Thus, only for the peak frequency, it is possible to estimate the accurate value by using the slope function. This is why only the slope function for the imaginary component Z" of the complex impedance corresponding to the peak frequency is derived.

Back in FIG. 10, the impedance estimator 140 may use the plurality of slope functions for the real components Z' of the complex impedances, thereby estimating the real component Z' of the complex impedance corresponding to the predetermined reference temperature for each of the plurality of frequencies. Moreover, the impedance estimator 140 may use the slope function for the imaginary component Z" of the complex impedance corresponding to the peak frequency of the arc component, thereby estimating the imaginary component Z" corresponding to the predetermined reference temperature. Then, the impedance estimator 140 estimates the arc component of the complex impedances, which is specifically a shape of the arc component of the Cole-Cole plot, by using the estimated real component Z' and the estimated imaginary component Z" of the impedance (step S24).

For the real component Z' of the complex impedance, a plurality of values are respectively estimated for the plurality of frequencies corresponding to the arc component. For the imaginary component Z" of the complex impedance, however, only one value corresponding to the peak frequency of the arc component is estimated. In other words, for the imaginary component Z" of the complex impedance, not all values corresponding to the plurality of frequencies corresponding to the arc component are estimated. However, a rough shape of the arc component, i.e., an upward arc shape as illustrated in FIG. 9, is already known. Thus, if the plurality of values of the real components Z' of the complex impedances corresponding to the plurality of frequencies and one value of the imaginary component Z" of the complex impedance corresponding to the peak frequency are known, the shape of the arc component can be accurately estimated.

The impedance estimator 140 uses the arc component of the complex impedance corresponding to the predetermined reference temperature, which is estimated in the above manner, thereby estimating the value Z of the complex impedance at any frequency corresponding to the arc component (step S25).

(3) Technical Effect

As explained above, according to the impedance estimating apparatus in the second embodiment, it is possible to estimate the complex impedance in the frequency band corresponding to the arc component of the Cole-Cole plot. In the frequency band corresponding to the arc component, as explained above, there is a part in which the slope function cannot be derived for the imaginary component Z" of the impedance, i.e., there is a part in which the linear relation indicated by the slope function is not established. It is, however, possible to estimate the shape of the arc component of the complex impedance by using the imaginary component Z" at the peak frequency at which the slope function can be used. As a result, it is possible to estimate the complex impedance corresponding to a desired temperature.

<Supplementary Notes>

Various aspects of embodiments of the present disclosure derived from the embodiments explained above will be explained hereinafter.

(Supplementary Note 1)

An impedance estimating apparatus described in Supplementary Note 1 is provided with: a deriving device configured to derive a slope function, on the basis of a value of a complex impedance of a battery at a predetermined frequency out of values obtained at a plurality of different temperatures and on the basis of a temperature of the battery when the complex impedance is obtained, wherein the slope function indicates a relation between the value of the complex impedance at the predetermined frequency and an inverse of the temperature of the battery; and an estimator configured to estimate a value of the complex impedance at the predetermined frequency corresponding to a desired temperature of the battery by using the slope function.
According to the impedance estimating apparatus described in Supplementary Note 1, the slope function may be derived on the basis of the value of the complex impedance of the battery at the predetermined frequency out of the values obtained at the plurality of different temperatures and on the basis of the temperature of the battery when the complex impedance is obtained. The slope function is derived as a function indicating the relation between the value of the complex impedance at the predetermined frequency and the inverse of the temperature of the battery. It is thus possible to estimate the value of the complex impedance at the predetermined frequency corresponding to the desired temperature of the battery by using the slope function. In other words, it is possible to estimate the complex impedance under a predetermined temperature condition, regardless of an actual temperature of the battery.

(Supplementary Note 2)

In an impedance estimating apparatus described in Supplementary Note 2, the deriving device is configured to use at least one of an absolute value and a real component of the complex impedance, as the value of the complex impedance at the predetermined frequency.
According to the impedance estimating apparatus described in Supplementary Note 2, by using at least one of the absolute value and the real component of the complex impedance, it is possible to estimate the complex impedance of the battery with relatively high accuracy, for example, in comparison with when an imaginary component of the complex impedance is used.

(Supplementary Note 3)

In an impedance estimating apparatus described in Supplementary Note 3, the slope function is expressed as a numerical expression, which his $\log Z = A \times (1/T) + B$, wherein A is a slope, B is an intercept, Z is the value of the complex impedance at the predetermined frequency, and T is the temperature of the battery.
According to the impedance estimating apparatus described in Supplementary Note 3, the slope function may be derived as a linear function. It is thus possible to extremely easily estimate the complex impedance of the battery.

(Supplementary Note 4)

In an impedance estimating apparatus described in Supplementary Note 4, the deriving device is configured to calculate another of the slope A and the intercept B, by using a temperature of the battery at which measurement accuracy is ensured and by using a value of the complex impedance at the predetermined frequency obtained at the temperature of the battery at which the measurement accuracy is ensured.

According to the impedance estimating apparatus described in Supplementary Note 4, it is possible to accurately calculate the slope A or the intercept B by using the temperature of the battery at which the measurement accuracy is ensured and by using the value of the complex impedance at the predetermined frequency obtained at the temperature at which the measurement accuracy is ensured.

(Supplementary Note 5)

In an impedance estimating apparatus described in Supplementary Note 5, the estimator is configured to store therein a plurality of slope functions respectively corresponding to a plurality of types of batteries, which are derived in advance by the deriving device, and the estimator is configured to determine the slope function that is used to estimate the value of the complex impedance at the predetermined frequency, from the plurality of slope functions stored, on the basis of a temperature at which measurement accuracy is ensured and on the basis of a value of the complex impedance at the predetermined frequency obtained at the temperature of the battery at which the measurement accuracy is ensured.

According to the impedance estimating apparatus described in Supplementary Note 5, an appropriate slope function according to the type of the battery whose complex impedance is to be estimated may be determined on the basis of the temperature at which the measurement accuracy is ensured and on the basis of the value of the complex impedance at the predetermined frequency obtained at the temperature of the battery at which the measurement accuracy is ensured. Thus, even if a plurality of types of batteries (or more specifically, a plurality of batteries in which different slope functions are derived) are targeted to estimate the complex impedances, it is possible to accurately estimate the complex impedances of the batteries.

(Supplementary Note 6)

An impedance estimating apparatus described in Supplementary Note 6 is provided with: a deriving device configured to derive a plurality of slope functions, on the basis of values of complex impedances of a battery at a plurality of frequencies out of values obtained at a plurality of different temperatures and on the basis of temperatures of the battery when the complex impedances are obtained, in a frequency area higher than an area of a Cole-Cole plot that belongs to ion diffusion, wherein each of the plurality of slope functions indicates respective one of relations between the values of the complex impedances at the plurality of frequencies and inverses of the temperatures of the battery; and an estimator configured (i) to estimate real components at the plurality of frequencies that form an arc component of the complex impedances by using the plurality of slope functions and to estimate an imaginary component at a peak frequency of the arc component of the complex impedances by using a slope function corresponding to the peak frequency from among the plurality of slope functions, (ii) to estimate the arc component of the complex impedances from the estimated real components and the estimated imaginary component, and (iii) to estimate a value of the complex impedance corresponding to a desired temperature of the battery from the estimated arc component.

According to the impedance estimating apparatus described in Supplementary Note 6, the complex impedances of the battery may be estimated in the frequency area higher than the area of the Cole-Cole plot that belongs to the ion diffusion. Specifically, firstly, the arc component of the complex impedances corresponding to the desired temperature of the battery may be estimated from the real components at the plurality of frequencies that form the arc component of the complex impedances and from the imaginary component at the peak frequency of the arc component of the complex impedances, by using the slope functions. Then, the value of the complex impedance at the predetermined frequency corresponding to the desired temperature of the battery may be estimated from the estimated arc component.

In the area of the Cole-Cole plot that belongs to the ion diffusion, the real component of the complex impedance has a constant relation between the value of the complex impedance and the inverse of the temperature of the battery; namely, the real component has a constant slope in the slope function. In contrast, the imaginary component of the complex impedance does not have a constant relation between the value of the complex impedance and the inverse of the temperature of the battery; namely, the imaginary component does not have a constant slope in the slope function. For the value at the peak frequency of the arc component of the complex impedances, however, the imaginary component of the complex impedance has a constant relation between the value of the complex impedance and the inverse of the temperature of the battery; namely, the imaginary component has a constant slop in the slope function.

It is therefore possible to accurately estimate the arc component of the complex impedances corresponding to the desired temperature of the battery, by using the real components at the plurality of frequencies that form the arc component of the complex impedances and by using the imaginary component at the peak frequency of the arc component of the complex impedances. If the arc component can be accurately estimated, the value of the complex impedance can be easily estimated.

The present disclosure may be embodied in other specific forms without departing from the spirit or essential characteristics thereof. The present embodiments and examples are therefore to be considered in all respects as illustrative and not restrictive, the scope of the disclosure being indicated by the appended claims rather than by the foregoing description and all changes which come in the meaning and range of equivalency of the claims are therefore intended to be embraced therein.

An impedance estimating apparatus is provided with: a deriving device configured to derive a slope function, on the basis of a value of a complex impedance of a battery at a predetermined frequency out of values obtained at a plurality of different temperatures and on the basis of a temperature of the battery when the complex impedance is obtained, wherein the slope function indicates a relation between the value of the complex impedance at the predetermined frequency and an inverse of the temperature of the battery; and an estimator configured to estimate a value of the complex impedance at the predetermined frequency corresponding to a desired temperature of the battery by using the slope function.

**Claims**

1. An impedance estimating apparatus (100) comprising:

   a deriving device (130) configured to derive a plurality of slope functions, on the basis of values of complex impedances of a battery (10) at a plurality of frequencies out of values obtained at a plurality of different temperatures and on the basis of temperatures of the battery (10) when the complex impedances are obtained, in a frequency area higher than an area of a Cole-Cole plot that belongs to ion diffusion, wherein each of the plurality of slope functions indicates respective one of relations between the values of the complex impedances at the plurality of frequencies and inverses of the temperatures of the battery (10); and
   an estimator (140) configured (i) to estimate, at a first temperature, real components at the plurality of frequencies that form a first arc component of the complex impedances by using the plurality of slope functions and to estimate an imaginary component at a peak frequency of the first arc component of the complex impedances by using a slope function corresponding to the peak frequency from among the plurality of slope functions, (ii) to estimate a second arc component of the complex impedances from the estimated real components and the estimated imaginary component, and (iii) to estimate a value of the complex impedance corresponding to a second temperature of the battery (10) from the second arc component.

**Patentansprüche**

1. Impedanzschätzvorrichtung (100), mit:

   einer Ableitungsvorrichtung (130), die dazu eingerichtet ist, um eine Vielzahl von Steigungsfunktionen abzuleiten, auf der Grundlage von Werten komplexer Impedanzen einer Batterie (10) bei einer Vielzahl von Frequenzen aus Werten, die bei einer Vielzahl von unterschiedlichen Temperaturen erhalten werden, und auf der Grundlage von Temperaturen der Batterie (10), wenn die komplexen Impedanzen erhalten werden, in einem Frequenzbereich, der höher als ein Bereich eines Cole-Cole-Plots ist, der zur Ionendiffusion gehört, wobei jede der Vielzahl von Steigungsfunktionen jeweils eine der Beziehungen zwischen den Werten der komplexen Impedanzen bei der Vielzahl von Frequenzen und Inverse der Temperaturen der Batterie (10) anzeigt; und
   einem Schätzer (140), der dazu eingerichtet ist, (i) um bei einer ersten Temperatur reale Komponenten bei der Vielzahl von Frequenzen, die eine erste Bogenkomponente der komplexen Impedanzen bilden, unter Verwendung der Vielzahl von Steigungsfunktionen zu schätzen und um eine imaginäre Komponente bei einer Peak-Frequenz der ersten Bogenkomponente der komplexen Impedanzen unter Verwendung einer Steigungsfunktion, die der Peak-Frequenz entspricht, aus der Vielzahl von Steigungsfunktionen zu schätzen, (ii) um eine zweite Bogenkomponente der komplexen Impedanzen aus den geschätzten realen Komponenten und der geschätzten imaginären Komponente zu schätzen, und (iii) um einen Wert der komplexen Impedanz, die einer zweiten Temperatur der Batterie (10) entspricht, aus der zweiten Bogenkomponente zu schätzen.

**Revendications**

1. Appareil d'estimation d'impédance (100) qui comprend :

   un dispositif de déduction (130) configuré pour déduire une pluralité de fonctions de pente, sur la base des valeurs d'impédances complexes d'une batterie (10) à une pluralité de fréquences parmi des valeurs obtenues à une pluralité de températures différentes et sur la base des températures de la batterie (10) lorsque les impédances complexes sont obtenues, dans une zone de fréquence supérieure à une zone d'un tracé Cole-Cole qui appartient à une diffusion d'ions, dans lequel chacune de la pluralité de fonctions de pente indique l'une respective des relations entre les valeurs des impédances complexes à la pluralité de fréquences et les inverses des températures de la batterie (10) ; et un estimateur (140) configuré (i) pour estimer, à une première température, des composantes réelles à la pluralité de fréquences qui forment une première composante d'arc des impédances complexes en utilisant la pluralité de fonctions de pente et pour estimer une composante imaginaire à une fréquence d'intensité maximum de la première composante d'arc des impédances complexes en utilisant une fonction de pente correspondant à la fréquence d'intensité maximum parmi la pluralité de fonctions de pente, (ii) pour estimer une deuxième composante d'arc des impédances complexes à partir des composantes réelles estimées et de la composante imaginaire estimée, et (iii) pour estimer une valeur de l'impédance complexe correspondant à une deuxième température de la batterie (10) à partir de la deuxième composante d'arc.

# FIG. 1

## FIG. 2

## FIG. 3

# FIG. 4

```
              ( Start )
                  |
                  v
    +---------------------------+   S11
    | Obtain a plurality of     |
    | impedances under a        |
    | plurality of temperature  |
    | conditions                |
    +---------------------------+
                  |
                  v
    +---------------------------+   S12
    | Substitute value (Z) of   |
    | impedance at predetermined|
    | frequency and temperature |
    | (T) when measured, into   |
    | equation                  |
    +---------------------------+
                  |
                  v
    +---------------------------+   S13
    | Calculate slope (A) and   |
    | intercept (B) of equation |
    +---------------------------+
                  |
                  v
    +---------------------------+   S14
    | Calculate value of        |
    | impedance at reference    |
    | temperature, from derived |
    | equation                  |
    +---------------------------+
                  |
                  v
              ( End )
```

FIG. 5

FIG. 6

# FIG. 7

FIG. 8

# FIG. 9

# FIG. 10

```
          ┌─────────────┐
          │    Start    │
          └─────────────┘
                 │
                 ▼                              S21
┌─────────────────────────────────┐
│ Obtain a plurality of impedances │
│ under a plurality of temperature │
│            conditions            │
└─────────────────────────────────┘
                 │                              S22
                 ▼
┌─────────────────────────────────┐
│     Substitute value (Z) of      │
│      impedance at a plurality    │
│  of frequencies and temperature (T) │
│  when measured, into equation    │
└─────────────────────────────────┘
                 │                              S23
                 ▼
┌─────────────────────────────────┐
│     Calculate slope (A) and      │
│     intercept (B) of equation    │
│ corresponding to the plurality of│
│            frequencies           │
└─────────────────────────────────┘
                 │                              S24
                 ▼
┌─────────────────────────────────┐
│   Estimate arc component from    │
│ values on real axis at a plurality│
│  of frequencies and from a value │
│   on imaginary axis at a peak    │
│             frequency            │
└─────────────────────────────────┘
                 │                              S25
                 ▼
┌─────────────────────────────────┐
│  Calculate value of impedance at │
│   reference temperature, from    │
│     estimated arc component      │
└─────────────────────────────────┘
                 │
                 ▼
          ┌─────────────┐
          │     End     │
          └─────────────┘
```

FIG. 11

Z'

Resistance value (Ω)

Temperature (1000/T)

EP 3 457 151 B1

FIG. 12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013114669 A
- JP 2014126532 A
- WO 2013018641 A
- JP 2008157757 A
- JP 3642092 B
- US 2016103184 A1
- US 2016187429 A1

**Non-patent literature cited in the description**

- **JIANG JIUCHUN et al.** Applied Energy. Elsevier Science Publishers